Europäisches Patentamt

European Patent Office

Office européen des brevets

(19)

(11) Veröffentlichungsnummer: **0 189 167 B1**

(12) **EUROPÄISCHE PATENTSCHRIFT**

(45) Veröffentlichungstag der Patentschrift: **24.04.91**

(51) Int. Cl.⁵: **H05K 13/04**

(21) Anmeldenummer: **86100707.8**

(22) Anmeldetag: **20.01.86**

(54) **Bestückungsautomat.**

(30) Priorität: **24.01.85 DE 3502257**

(43) Veröffentlichungstag der Anmeldung:
**30.07.86 Patentblatt 86/31**

(45) Bekanntmachung des Hinweises auf die
Patenterteilung:
**24.04.91 Patentblatt 91/17**

(84) Benannte Vertragsstaaten:
**AT BE CH DE FR GB IT LI LU NL SE**

(56) Entgegenhaltungen:
**EP-A- 0 016 368**
**DE-A- 3 424 323**
**US-A- 4 063 347**

(73) Patentinhaber: **Buck, Robert**
**Vogelherdbogen 67**
**W-7992 Tettnang(DE)**

Patentinhaber: **Marhofer, Gerd**
**Beckmannsbusch 67**
**W-4300 Essen-Bredeney(DE)**

(72) Erfinder: **Buck, Robert**
**Vogelherdbogen 67**
**W-7992 Tettnang(DE)**
Erfinder: **Marhofer, Gerd**
**Beckmannsbusch 67**
**W-4300 Essen-Bredeney(DE)**

(74) Vertreter: **Gesthuysen, Hans Dieter, Dipl.-Ing.**
**et al**
**Patentanwälte Gesthuysen + von Rohr**
**Huyssenallee 15 Postfach 10 13 33**
**W-4300 Essen 1(DE)**

## Beschreibung

Die Erfindung betrifft einen Bestückungsautomaten für das Bestücken von Bauelementeträgern mit anschlußdrahtlosen Bauelementen (Chip-Bauelementen), die in auf Gurtrollen aufgewickelten Gurten zur Verfügung stehen (gegurtete Bauelemente), mit einer vorzugsweise als Vorschubeinrichtung in Längsrichtung (Längsrichtung = X-Richtung) arbeitenden Bauelementeträgeraufnahme, mit einer eine Positioniereinheit und einen Bestückungskopf aufweisenden "Pick-and-Place"-Einrichtung und mit einer Bauelementebereitstellungseinrichtung für die gegurteten Bauelemente, wobei die Bauelementebereitstellungseinrichtung eine Aufnahmeeinheit für die Gurtrollen, eine Gurtführung mit einer Mehrzahl von Gurtführungsbahnen, einen Gurttransport und eine Abzieheinheit für das Abdeckmaterial der Gurte aufweist, wobei die Aufnahmeeinheit für die Gurtrollen, die Gurtführung und die Abzieheinheit für das Abdeckmaterial der Gurte zu einer in X-Richtung verfahrbaren Baueinheit zusammengefaßt sind, wobei die Abzieheinheit für das Abdeckmaterial der Gurte eine der Anzahl der Gurtrollen entsprechende Anzahl von Abziehrollen und einen Abziehantrieb aufweist und wobei für jeden einzelnen Bestückungsvorgang jeweils ein Gurt in eine fest vorgegebene Bauelemententnahmeposition gebracht wird.

In zunehmendem Maße werden - platten- oder bandförmige - Bauelementeträger - statt wie früher mit bedrahteten Bauelementen - mit anschlußdrahtlosen Bauelementen bestückt, die im folgenden als Chip-Bauelemente bezeichnet werden. Dabei meint Chip-Bauelemente nicht nur kubische Chip-Widerstände und -Kondensatoren, sondern alle "leadless"-Bauelemente sowie alle planaren Bauelemente, deren Anschlüsse nicht in den Bauelementeträger "eingesetzt", sondern "aufgesetzt" werden (z. B. MELFs, Schaltkreise im SO-Gehäuse und im DIL-Gehäuse usw.).

Die Verwendung von Chip-Bauelementen führt gegenüber der Verwendung bedrahteter Bauelemente zu höherer Packungsdichte, höherer Zuverlässigkeit und automatisierungsfreundlicherer Bestückungstechnik.

Für das automatische Bestücken von Bauelementeträgern mit Chip-Bauelementen sind zwischenzeitlich Bestückungsautomaten entwickelt worden, die in ihrem grundsätzlichen Aufbau aus einer Bauelementeträgeraufnahme, einer eine Positioniereinheit und einen Bestückungskopf aufweisenden "Pick-and-Place"-Einrichtung und einer Bauelementebereitstellungseinrichtung bestehen.

Chip-Bauelemente werden von den Bauelementeherstellern einerseits in Beuteln, andererseits in auf Gurtrollen aufgewickelten Gurten zur Verfügung gestellt. Bei der Verwendung von in Beuteln zur Verfügung gestellten Chip-Bauelementen gehört zur Bauelementebereitstellungseinrichtung von Bestückungsautomaten z. B. ein Vibrationslängsförderer, ein Vibrationsrundförderer oder ein Vibrationsrechteckförderer. Sollen in auf Gurtrollen aufgewickelten Gurten zur Verfügung gestellte Chip-Bauelemente (gegurtete Bauelemente) verwendet werden, so gehört zur Bauelementebereitstellungseinrichtung von Bestückungsautomaten eine Aufnahmeeinheit für die Gurtrollen, eine Gurtführung mit einer Mehrzahl von Gurtführungsbahnen, ein Gurttransport und eine Abzieheinheit für das Abdeckmaterial der Gurte.

Zu diesem Stand der Technik, und zwar in bezug auf Chip-Bauelemente, in bezug auf das automatische Bestücken von Bauelementeträgern mit Chip-Bauelementen und in bezug auf Bestükkungsautomaten für das Bestücken von Bauelementeträgern mit Chip-Bauelementen, wird zunächst allgemein verwiesen auf die SIEMENS-Druckschrift "Bestückungsautomat für Chip und planare Bauelemente", SIEMENS-Druckschrift Mch 01710.835.

Bei dem zuvor genannten Stand der Technik (vgl. die SIEMENS-Druckschrift "Bestückungsautomat für Chip und planare Bauelemente", insbesondere Seite 8, linke Spalte, Seite, linke Spalte, Seiten 10 bis 16 und Seiten 21 ff.), ist die Bauelementebereitstellungseinrichtung so ausgeführt, daß für jede Gurtrolle (oder für ein Paar von Gurtrollen) eine besondere Gurtführung, eine besondere Gurttransporteinheit und ein besonderer Abziehantrieb vorgesehen sind. Im montierten Zustand bilden die Aufnahmeeinheit für die Gurtrollen, die Gurtführungen, die Gurttransporteinheiten und die Abzieheinheit mit den Abziehantrieben eine ortsfeste Baueinheit.

Mit Hilfe des zuvor erläuterten Bestückungsautomaten läuft das Bestücken von Bauelementeträgern mit Chip-Bauelementen bezüglich der Bauelementebereitstellungseinrichtung wie folgt ab:

Ausgangspunkt der Betrachtung ist der Zustand des Bestückungsautomaten, bei dem sich alle Gurte in der Position befinden, in der der Bestückungskopf der "Pick-and-Place"-Einrichtung nacheinander den einzelnen Gurten jeweils ein Chip-Bauelement entnehmen kann. Nach dem Beginn des Bestückens entnimmt der Bestückungskopf der "Pick-and-Place"-Einrichtung den einzelnen Gurten fortlaufend jeweils ein Chip-Bauelement, das mit Hilfe der "Pick-and-Place"-Einrichtung auf den zu bestückenden Bauelementeträger an einer vorgegebenen Stelle aufgesetzt wird. Gleich nach Entnahme des jeweiligen Chip-Bauelementes wird der Gurt-Transport durch den Bestükkungskopf selbst ausgelöst. D. h. gleich nach Entnahme eines jeweiligen Chip-Bauelementes befindet sich der betreffende Gurt - wie alle anderen Gurte auch - in der Position, in der der Bestük- kungskopf der "Pick-and-Place"-Einrichtung nacheinander den einzelnen Gurten jeweils ein weiteres Chip-Bauelement entnehmen kann.

Aus der zuvor in bezug auf die Bauelemente- bereitstellungseinrichtung gegebenen Funktionswei- se des bekannten Bestückungsautomaten, von dem die Erfindung ausgeht, wird deutlich, daß nach erneuter Verbringung der jeweiligen Gurte in die Position, in der der Bestückungskopf der "Pick-and- Place"-Einrichtung den einzelnen Gurten nacheinander jeweils wieder ein Chip-Bauelement entnehmen kann, eine Vielzahl von auch nicht andeutungsweise ausgenutzten Gurttransporteinheiten vorhanden ist. Sind z. B. 48 Gurte vorhanden, so führen jeweils nach Entnahmen von Chip-Baucle- menten durch den Bestückungskopf jeweils 48 Gurttransporteinheiten (oder 24 Gurttransporteinheiten, wenn jeweils einem Paar von Gurten eine Gurttransporteinheit zugeordnet ist) nacheinander einen Transportschritt durch. Danach werden die Gurttransporteinheiten solange nicht mehr benutzt, bis der Bestückungskopf der "Pick-and-Place"-Einrichtung dem jeweiligen Gurt das für die Bestük- kung eines Bauelementeträgers erforderliche Chip- Bauelement entnommen hat und danach den Gurt- Transport selbst ausgelöst hat.

Die voranstehenden Erläuterungen machen deutlich, daß der zuvor behandelte Bestückungsau- tomat hinsichtlich der Bauelementebereitstellungs- einrichtung sehr aufwendig ist. Es ist aber auch schon ein hinsichtlich der Bauelementebereitstel- lungseinrichtung etwas einfacherer Bestückungsau- tomat bekannt geworden (DE-OS 34 24 323), bei dem die Aufnahmeeinheit für die Gurtrollen, die Gurtführung und die Abzieheinheit für das Abdeckmaterial der Gurte zu einer in X-Richtung verfahrbaren Baueinheit zusammengefaßt sind. Hier arbeitet die "Pick-and-Place"-Einrichtung von einer festen Bauelemententnahmeposition aus, in die für jeden einzelnen Bestückungsvorgang der jeweils interessierende Gurt gebracht wird. Der Gurttransport weist in der in X-Richtung verfahrbaren Baueinheit je Gurt eine Zahn-Transportwalze auf. Diese ist über ein Zwischenzahnrad und ein Reibrad mit der entsprechend zugeordneten Abziehrolle für das Abdeckmaterial des Gurtes verbunden. Eine Gurtrolle, eine Gurtführung, eine Gurtführungsbahn, die genannten Teile des Gurttransports und eine solche Abzieheinheit bilden eine einzelne Kassette, von denen die Baueinheit eine Mehrzahl aufweist. In der Bauelemententnahmeposition greift ein im Grundsatz beliebig gearteter, ortsfester Antrieb über ein Hebelgetriebe an der Zahn-Transportwalze an und verursacht so den erforderlichen Gurttransport und den erforderlichen Transport des Abdeckmaterials des Gurtes.

Bei dem zuvor erläuterten Bestückungsautomaten ist zwar eine Vereinfachung der Bauelementebereitstellungseinrichtung dadurch erfolgt, daß nur eine ortsfeste Antriebseinrichtung vorhanden ist, jedoch ist die Bauelementebereitstellungseinrichtung immer noch sehr aufwendig, da die erläuterten Transportwalzen und Zahnräder sämtlich in einer der Anzahl der Gurte entsprechenden Anzahl vorhanden sein müssen.

Ausgehend von dem zuvor erläuterten, bekannten Bestückungsautomaten liegt der Erfindung nun die Aufgabe zugrunde, einen bezüglich der Bauele- mentebereitstellungseinrichtung weniger aufwendi- gen Bestückungsautomaten anzugeben.

Der erfindungsgemäße Bestückungsautomat, bei dem die zuvor aufgezeigte Aufgabe gelöst ist, ist dadurch gekennzeichnet, daß in der Bauelemen- tentnahmeposition ortsfest einerseits der Gurttrans- port in Form einer einzelnen, am in die Bauelemententnahmeposition und damit in eine dadurch fest vorgegebene Gurttransportstellung gebrachten Gurt direkt angreifenden Gurttransporteinheit, andererseits der Abziehantrieb in Form einer einzelnen, an der damit in eine entsprechend fest vorgegebene Abziehstellung gebrachten Abziehrolle direkt angreifenden Abziehantriebseinheit angeordnet ist. Der erfindungsgemäße Bestückungsautomat weist also nur eine einzige Gurttransporteinheit in der Bauelemententnahmeposition auf, die direkt am Gurt angreift und folglich keine Transportwalze je Gurt, sondern nur ein Kraftübertragungselement, beispielsweise eine Transportwalze oder einen Transportstift, für alle Gurte benötigt. In entsprechender Weise weist auch die Abzieheinheit neben den notwendigerweise vorhandenen Abziehrollen in der Anzahl der Gurte entsprechenden Anzahl nur noch eine einzige, direkt an der jeweils interessie- renden Abziehrolle angreifende Abziehantriebsein- heit auf. Weitere Bauteile des Gurttransports oder der Abzieheinheit in einer der Anzahl der Gurte entsprechenden Anzahl sind nicht mehr vorhanden.

Im folgenden werden die Lehre der Erfindung sowie Ausgestaltungen und Weiterbildungen der Lehre der Erfindung anhand eines zeichnerisch dargestellten Ausführungsbeispiels näher erläutert; es zeigt

Fig. 1    schematisch, perspektivisch einen Be- stückungsautomaten für das Bestük- ken von Bauelementeträgern mit ge- gurteten Chip-Bauelementen,

Fig. 2    in gegenüber der Fig. 1 vergrößerter Darstellung, einen Ausschnitt aus dem Gegenstand nach Fig. 1,

Fig. 3    einen Teil einer Bauelementebereit- stellungseinrichtung eines Bestük- kungsautomaten,

Fig. 4    schematisch, perspektivisch einen Ausschnitt aus einer Bauelementebereitstellungseinrichtung einer bevorzugten Ausführungsform eines erfindungsgemäßen Bestückungsautomaten,

Fig. 5    in gegenüber der Fig. 4 vergrößerten Darstellung, einen Ausschnitt aus dem Gegenstand nach Fig. 4 und

Fig. 6    schematisch, einen Ausschnitt aus einer Abzieheinheit einer bevorzugten Ausführungsform eines erfindungsgemäßen Bestückungsautomaten.

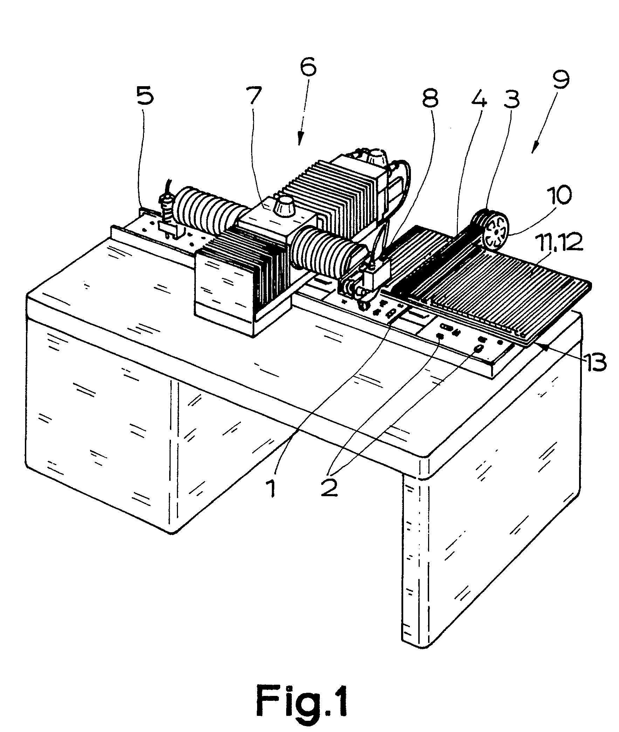

Der in Fig. 1 schematisch dargestellte Bestückungsautomat ist bestimmt für das Bestücken von Bauelementeträgern 1 mit Chip-Bauelementen 2, d. h. mit anschlußdrahtlosen Bauelementen, und zwar gegurteten Bauelementen, also solchen, die in auf Gurtrollen 3 aufgewickelten Gurten 4 zur Verfügung stehen. Zu dem dargestellten Bestückungsautomaten gehören eine als Vorschubeinrichtung in Längsrichtung (Längsrichtung = X-Richtung) arbeitende Bauelementeträgeraufnahme 5, eine "Pick-and-Place"-Einrichtung 6 mit einer Positioniereinheit 7 und einem Bestückungskopf 8 und eine Bauelementebereitstellungseinrichtung 9, wobei die Bauelementebereitstellungseinrichtung 9 eine Aufnahmeeinheit 10 für die Gurtrollen 3, eine Gurtführung 11 mit einer Mehrzahl von Gurtführungsbahnen 12, einen Gurttransport 13 und eine Abzieheinheit 14 für das Abdeckmaterial 15 der Gurte 4 aufweist.

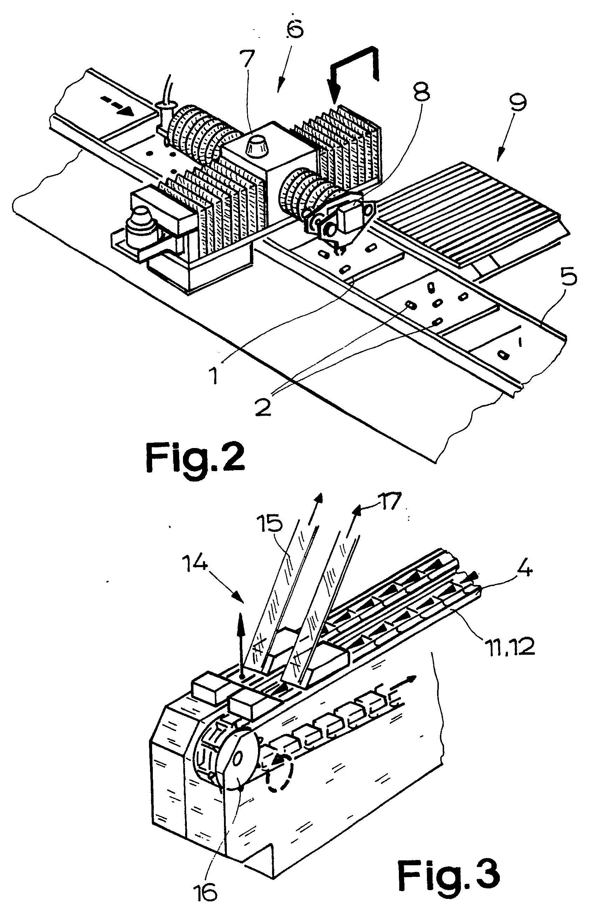

In Fig. 3 ist ein bekannter Bestückungsautomat nur angedeutet. Für jede Gurtrolle 3 bzw. für ein Paar von Gurtrollen 3 sind hier eine besondere Gurtführung 11, besondere Gurttransporteinheiten 16 und ein besonderer Abziehantrieb 17 vorgesehen. In montiertem Zustand bilden die Aufnahmeeinheit 10 für die Gurtrollen 3, die Gurtführungen 11, die Gurttransporteinheiten 16 und die Abzieheinheit 14 eine Baueinheit.

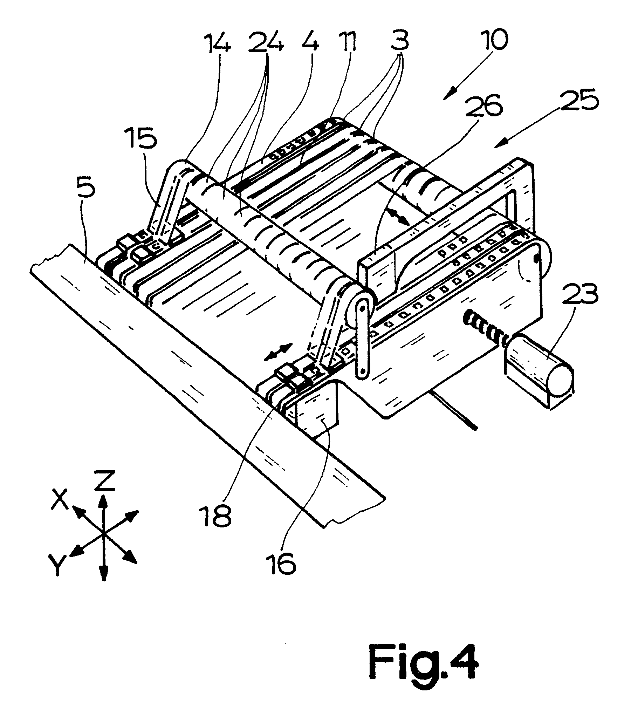

Aus einer Zusammenschau der Fig. 1 und 2 mit den Fig. 4 bis 6 läßt sich erkennen, daß hier die Aufnahmeeinheit 10 für die Gurtrollen 3, die Gurtführung 11 und die Abzieheinheit 14 für das Abdeckmaterial 15 der Gurte 4 zu einer in X-Richtung verfahrbaren Baueinheit zusammengefaßt sind. Dabei weist die Abzieheinheit 14 für das Abdeckmaterial 15 der Gurte 4 eine der Anzahl der Gurtrollen 3 entsprechende Anzahl von Abziehrollen 24 und einen Abziehantrieb 25 auf. Für jeden einzelnen Bestückungsvorgang wird jeweils ein Gurt 4 in eine fest vorgegebene Bauelemententnahmeposition gebracht. Wesentlich ist dabei nun, daß in der Bauelemententnahmeposition ortsfest einerseits der Gurttransport 13 in Form einer einzelnen, am in die Bauelemententnahmeposition und damit in eine dadurch fest vorgegebene Gurttransportstellung gebrachten Gurt 4 direkt angreifenden Gurttransporteinheit 16, andererseits der Abziehantrieb 25 in Form einer einzelnen, an der damit in eine entsprechend fest vorgegebene Abziehstellung gebrachten Abziehrolle 24 direkt angreifenden Abziehantriebseinheit 26 angeordnet ist. Diese Konstruktion gewährleistet einen besonders einfachen Aufbau des Bestückungsautomaten, da nämlich nur noch die Teile in einer der Anzahl der Gurte 4 entsprechenden Anzahl vorhanden sind, die bei extern angeordneten Antrieben unbedingt vorhanden sein müssen.

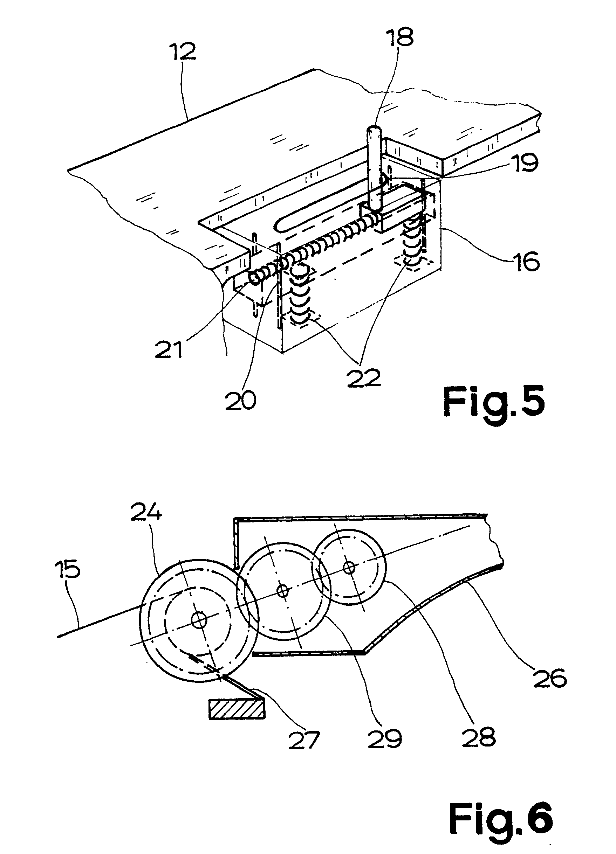

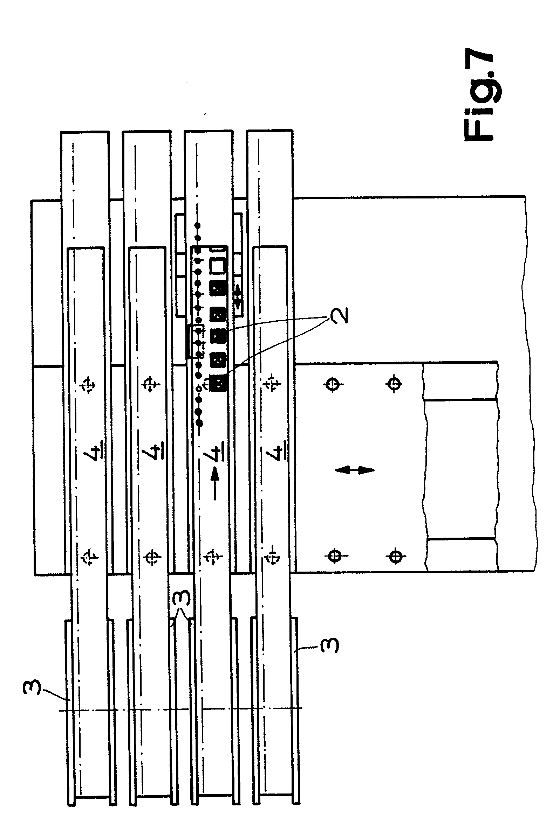

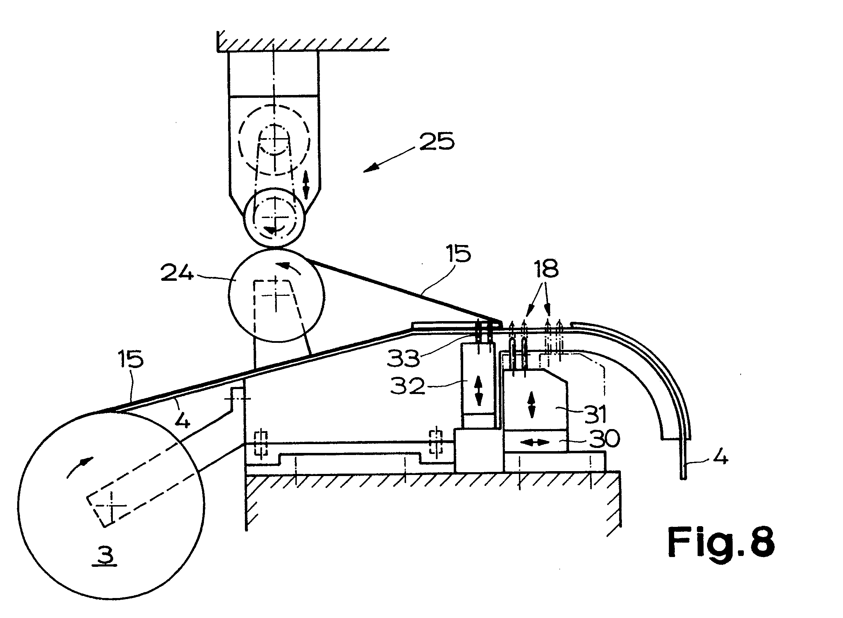

Wie die Fig. 4 und 5 zeigen, ist das hier angedeutete Ausführungsbeispiel eines Bestückungsautomaten weiter dadurch gekennzeichnet, daß die Gurttransporteinheit 16 einen Transportstift 18 aufweist und der Transportstift 18 in Querrichtung (Querrichtung = Y-Richtung) und in vertikaler Richtung (vertikale Richtung = Z-Richtung) bewegbar ist. Im einzelnen weist die Gurttransporteinheit 16 für den Transportstift 18 eine Y-Führung 19 und eine Z-Führung 20 auf, die im dargestellten Ausführungsbeispiel als Führungsschlitze ausgeführt sind, und ist der Transportstift 18 durch Federbelastung in seiner Ausgangsposition gehalten, nämlich durch eine Y-Feder 21 und durch eine Z-Feder 22, die jeweils als Druckfedern ausgeführt sind. Mit Hilfe nicht dargestellter pneumatisch betätigbarer Zylinder-Kolben-Anordnungen ist der Transportstift 18 bewegbar. (Bei bekannten Bestückungsautomaten ist es für sich bekannt, die Gurttransporteinheit 16 in der zuvor beschriebenen Weise mit einem Transportstift 18 auszuführen, so daß es sich erübrigt, hier weiter ins Detail zu gehen.)

Im Ausführungsbeispiel sind die Aufnahmeeinheit 10 für die Gurtrollen 3, die Gurtführung 11 und die Abzieheinheit 14 für das Abdeckmaterial 15 der Gurte 4 zu einer in X-Richtung verfahrbaren Baueinheit zusammengefaßt. Für das Verfahren der Gurtführung 11 bzw. der Baueinheit aus der Aufnahmeeinheit 10 für die Gurtrollen 3, der Gurtführung 11 und der Abzieheinheit 14 für das Abdeckmaterial 15 ist ein Spindelantrieb 23 vorgesehen.

Nicht dargestellt ist in den Figuren, daß bei dem Bestückungsautomaten, wie an sich bekannt, die entleerten Gurte nach unten wegführbar sind und daß eine den entleerten Gurten zugeordnete Schneideinrichtung vorgesehen sein kann.

Wie der Fig. 6 entnommen werden kann, ist jeder Abziehrolle 24 ein Bremselement 27 zugeordnet, das nur in der der Abziehrichtung entgegengesetzten Richtung bremsend wirksam und als Blattfeder ausgeführt ist.

Schließlich kann der Fig. 6 noch insoweit eine besondere Maßnahme entnommen werden, als die Abziehantriebseinheit 26 einen Elektromotor 28 aufweist, und zwar einen Gleichstrommotor, so daß mit Hilfe einer Steuerung oder Regelung des Ankerstromes des Elektromotors 28 das Antriebsmoment des Elektromotors 28 und damit die Abziehkraft der mit der Abziehantriebseinheit 26 gekuppelten Abziehrolle 24 gesteuert oder geregelt ist. Zwischen dem Elektromotor 28 und der mit der Abziehantriebseinheit 26 gekuppelten Abziehrolle 24 ist ein Drehmomentübertragungsrad 29 vorgesehen.

**Ansprüche**

1. Bestückungsautomat für das Bestücken von Bauelementeträgern mit anschlußdrahtlosen Bauelementen, die in auf Gurtrollen aufgewikkelten Gurten zur Verfügung stehen, mit einer vorzugsweise als Vorschubeinrichtung in Längsrichtung arbeitenden Bauelementeträgeraufnahme, mit einer eine Positioniereinheit und einen Bestückungskopf aufweisenden "Pickand-Place"-Einrichtung und mit einer Bauelementebereitstellungseinrichtung für die gegurteten Bauelemente, wobei die Bauelementebereitstellungseinrichtung eine Aufnahmeeinheit für die Gurtrollen, eine Gurtführung mit einer Mehrzahl von Gurtführungsbahnen, einen Gurttransport und eine Abzieheinheit für das Abdeckmaterial der Gurte aufweist, wobei die Aufnahmeeinheit für die Gurtrollen, die Gurtführung und die Abzieheinheit für das Abdeckmaterial der Gurte zu einer in X-Richtung verfahrbaren Baueinheit zusammengefaßt sind, wobei die Abzieheinheit für das Abdeckmaterial der Gurte eine der Anzahl der Gurtrollen entsprechende Anzahl von Abziehrollen und einen Abziehantrieb aufweist und wobei für jeden einzelnen Bestückungsvorgang jeweils ein Gurt in eine fest vorgegebene Bauelemententnahmeposition gebracht wird, **dadurch gekennzeichnet**, daß in der Bauelemententnahmeposition ortsfest einerseits der Gurttransport (13) in Form einer einzelnen, am in die Bauelemententnahmeposition und damit in eine dadurch fest vorgegebene Gurttransportstellung gebrachten Gurt (4) direkt angreifenden Gurttransporteinheit (16), andererseits der Abziehantrieb (25) in Form einer einzelnen, an der damit in eine entsprechend fest vorgegebene Abziehstellung gebrachten Abziehrolle (24) direkt angreifenden Abziehantriebseinheit (26) angeordnet ist.

2. Bestückungsautomat nach Anspruch 1, dadurch gekennzeichnet, daß die Gurttransporteinheit (16) einen Transportstift (18) aufweist und der Transportstift (18) in Querrichtung und in vertikaler Richtung bewegbar ist.

3. Bestückungsautomat nach Anspruch 2, dadurch gekennzeichnet, daß die Gurttransporteinheit (16) für den Transportstift (18) eine Y-Führung (19) und/oder eine Z-Führung (20) aufweist.

4. Bestückungsautomat nach Anspruch 3, dadurch gekennzeichnet, daß die Y-Führung (19) und/oder die Z-Führung (20) als Führungsschlitz ausgeführt ist.

5. Bestückungsautomat nach einem der Ansprüche 2 bis 4, dadurch gekennzeichnet, daß der Transportstift (18) durch Federbelastung in seiner Ausgangsposition gehalten ist.

6. Bestückungsautomat nach Anspruch 5, dadurch gekennzeichnet, daß der Transportstift (18) durch eine Y-Feder (21) und durch eine Z-Feder (22) in seiner Ausgangsposition gehalten ist.

7. Bestückungsautomat nach Anspruch 6, dadurch gekennzeichnet, daß die Y-Feder (21) und die Z-Feder (22) als Druckfedern ausgeführt sind.

8. Bestückungsautomat nach einem der Ansprüche 2 bis 7, dadurch gekennzeichnet, daß der Transportstift (18) mit Hilfe pneumatisch betätigbarer Zylinder-Kolben-Anordnungen bewegbar ist.

9. Bestückungsautomat nach einem der Ansprüche 1 bis 8, dadurch gekennzeichnet, daß jeder Abziehrolle (24) ein Bremselement (27) zugeordnet ist.

10. Bestückungsautomat nach Anspruch 9, dadurch gekennzeichnet, daß das Bremselement (27) nur in der der Abziehrichtung entgegengesetzten Richtung bremsend wirksam ist.

11. Bestückungsautomat nach Anspruch 10, dadurch gekennzeichnet, daß das Bremselement (27) als Blattfeder ausgeführt ist.

12. Bestückungsautomat nach einem der Ansprüche 1 bis 11, dadurch gekennzeichnet, daß die Abziehantriebseinheit (26) einen Elektromotor (28) aufweist.

13. Bestückungsautomat nach Anspruch 12, dadurch gekennzeichnet, daß als Elektromotor (28) ein Gleichstrommotor vorgesehen ist und mit Hilfe einer Steuerung oder Regelung des Ankerstromes des Elektromotors (28) das Antriebsmoment des Elektromotors (28) und damit die Abziehkraft der mit der Abziehantriebseinheit (26) gekuppelten Abziehrolle (24) gesteuert oder geregelt ist.

14. Bestückungsautomat nach Anspruch 12 oder 13, dadurch gekennzeichnet, daß zwischen dem Elektromotor (28) und der mit der Abziehantriebseinheit (26) gekuppelten Abziehrolle (24) mindestens ein Drehmomentübertragungsrad (29) vorgesehen ist.

**Claims**

1. Automatic mounting apparatus for mounting components of a leadless type on circuit boards, said components of a leadless type being provided on belts wound upon belt-rolls, with a circuit board receiver working preferably as carriage control in a longitudinal direction, with a "Pick-and-Place"-means comprising a positioning means and an assembly head and with a component placing means for the taped components, wherein said component placing means comprising a reception means for the belt-rolls, a belt guide with a plurality of belt guideways, a belt conveyance and a yank off means for the covering material of the belts, wherein said reception means for the belt-rolls, said belt guide and said yank off means for the covering material of the belts building a unit locomotive in a longitudinal direction, wherein said yank off means for the covering material of the belts comprising a number of yank off rolls corresponding to the number of belt-rolls and a yank off drive and wherein for every single mounting action a respective single belt being brought into a predefined component-pick-up position, **characterized in that** in the component-pick-up position being disposed stationary on the one hand the belt conveyance (13) as a single belt conveyance unit (16) acting directly upon a belt (4) being brought into the component-pick-up position and thereby being brought into a therewith predefined belt conveyance position, on the other hand the yank off drive (25) as a single yank off drive unit (26) acting directly upon a yank off roll (24) being brought thereby in a corresponding predefined yank off position.

2. Automatic mounting apparatus following claim 1, characterized in that the belt conveyance unit (16) having a conveyance pin (18) and said conveyance pin (18) being movable in a cross direction and in a vertical direction.

3. Automatic mounting apparatus following claim 2, characterized in that the belt conveyance unit (16) having a cross guide (19) and/or a vertical guide (20) for the conveyance pin (18).

4. Automatic mounting apparatus following claim 3, characterized in that the cross guide (19) and/or the vertical guide (20) being formed as a guide slot.

5. Automatic mounting apparatus following one of claims 2 to 4, characterized in that the conveyance pin (18) being held in its starting position by spring loading.

6. Automatic mounting apparatus following claim 5, characterized in that the conveyance pin (18) being held in its starting position by a cross spring (21) and a vertical spring (22).

7. Automatic mounting apparatus following claim 6, characterized in that the cross spring (21) and the vertical spring (22) being formed as compression springs.

8. Automatic mounting apparatus following one of claims 2 to 7, characterized in that the conveyance pin (18) being movable by pneumatic operating cylinder-piston-means.

9. Automatic mounting apparatus following one of claims 1 to 8, characterized in that every yank off roll (24) having a corresponding brake-element (27).

10. Automatic mounting apparatus following claim 9, characterized in that the brake-element (27) only retarding in a direction contrary to the yank off direction.

11. Automatic mounting apparatus following claim 10, characterized in that the brake-element (27) being formed as a leaf spring.

12. Automatic mounting apparatus following one of claims 1 to 11, characterized in that the yank off drive unit (26) having a electromotor (28).

13. Automatic mounting apparatus following claim 12, characterized in that the electromotor (28) being provided as a dc-motor and the torque of the electromotor (28) being control able by a control of the armature current of the electromotor (28) and thereby the yank off force of the yank off roll (24) linked to the yank off drive unit (26) being controlled.

14. Automatic mounting apparatus following claim 12 or 13, characterized in that between the electromotor (28) and the yank off roll (24) linked to the yank off drive unit (26) being provided at least one torque transmission wheel (29).

**Revendications**

1. Appareil automatique de montage pour la montage des porteurs de composants avec composants sans sortie, lesdits composants étant à la disposition par des sangles enroulées sur des bobines de sangle, avec un logement de porteur de composants agissant de préférence comme commande de sant vers une direction longitudinale, avec un dispositif de "Pick-and-Place" contenant un dispositiv de positionnement et une tête à équiper et avec un dispositiv d'approvisionnement de composants pour les componants sur bande, ledit dispositiv d'approvisionnement de composants ayant une unité de logement pour les bobines de sangle, un guidage de sangle avec plusieures glissières de guidage de sangle, un transport de sangle et un démonte-roue pour le materiau de couverture des sangles, ladite unité de logement pour les bobines, ledit guidage de sangle et ledit démonte-roue pour le matériau de couverture des sangles formant ensemble une unité déplaçable vers une direction longitudinale, ledit démonte-roue pour le matériau de couverture des sangles ayant un nombre des bobines de démonte correspondant au nombre des bobines de sangle et ayant un actionnement de démonte et pour chaque processus de montage une sangle étant déplacée dans une position de prise deplacé dans une position de prise de composants prédéfinie, **caractérisé en ce que** dans la position de prise de composants étant disposés fixement de l'un côté le transport de sangle (13) sous forme d'une seule unité de transport de sangle (16) agissant directement sur une sangle (4) étant transportée dans la position de prise de composants et donc dans une position de transport de sangle prédéfinie par cela, de l'antre côté l'actionnement de démonte (25) sous forme d'une seule unité d'actionnement de démonte (26) agissant directement sur ladite bobine de démonte (24) étant transportée dans une position de démonte de composants correspondante et prédéfinie par cela.

2. Appareil automatique de montage suivant la revendication 1, caractérisé en ce que ladite unité de transport de sangle (16) ayant une broche de transport (18) et la broche de transport (18) étant déplaçable vers une direction transversale et vers une direction verticale.

3. Appareil automatique de montage suivant la revendication 2, caractérisé en ce que ladite unité de transport de sangle (16) ayant une glissière de guidage transversale (19) et/ou une glissière de guidage verticale (20) pour la broche de transport (18).

4. Appareil automatique de montage suivant la revendication 3, caractérisé en ce que la glissière de guidage transversale (19) et/ou la glissière de guidage verticale (20) étant formées comme rainure de guidage.

5. Appareil automatique de montage suivant l'une des revendications 2 à 4, caractérisé en ce que ladite broche de transport (18) étant arrêtée sous l'action d'un ressort dans sa position de départ.

6. Appareil automatique de montage suivant la revendication 5, caractérisé en ce que ladite broche de transport (18) étant arrêtée dans sa position de départ par un ressort transversal (21) et par un ressort vertical (22).

7. Appareil automatique de montage suivant revendication 6, caractérisé en ce que ledit ressort transversal (21) et ledit ressort vertical (22) étant des ressorts de pression.

8. Appareil automatique de montage suivant l'une des revendications 2 à 7, caractérisé en ce que ladite broche de transport (18) étant déplaçable par des dispositifs cylindre-piston à actionner pneumatiquement.

9. Appareil automatique de montage suivant l'une des revendications 1 à 8, caractérisé en ce que chaque bobine de démonte (24) ayant un élément de freinage (27) correspondant.

10. Appareil automatique de montage suivant la revendication 9, caractérisé en ce que l'élément de freinage (27) étant activ comme frein seulement dans une direction opposée à la direction de démonte.

11. Appareil automatique de montage suivant la revendication 10, caractérisé en ce que l'élement de freinage (27) étant formé comme ressort à lames.

12. Appareil automatique de montage suivant l'une des revendications 1 à 11, caractérisé en ce que ladite unité d'actionnement de démonte (26) ayant un moteur éléctrique (28).

**13.** Appareil automatique de montage suivant la revendication 12, caractérisé en ce que ledit moteur éléctrique (28) étant un moteur à courant continu et à l'aide d'un réglage ou contrôle de courant d'induit du moteur éléctrique (28) le moment du moteur éléctrique (28) et donc la force de démonte de la bobine de démonte (24) couplée á l'unité d'actionnement de démonte (26) étant contrôlée ou réglée.

**14.** Appareil automatique de montage suivant l'une des revendications 12 ou 13, caractérisé en ce que entre ledit moteur éléctrique (28) et la bobine de démonte (24) couplée à l'unité d'actionnement de démonte (26) étant prévue au moins une roue de transmission de moment (29).

Fig.1

**Fig.2**

**Fig.3**

**Fig.4**

**Fig.5**

**Fig.6**

**Fig.7**

EP 0 189 167 B1

Fig.8

EP 0 189 167 B1